(19) Europäisches Patentamt
European Patent Office
Office européen des brevets

(11) Veröffentlichungsnummer: **0 044 274**
**B1**

(12) # EUROPÄISCHE PATENTSCHRIFT

(45) Veröffentlichungstag der Patentschrift: **11.09.85**

(21) Anmeldenummer: **81810271.7**

(22) Anmeldetag: **06.07.81**

(51) Int. Cl.⁴: **C 08 K 5/41,** C 08 F 2/50, C 08 L 63/00, C 08 L 25/00, C 08 L 61/00, G 03 C 1/68, G 03 F 7/10, H 01 L 21/312, C 09 J 3/14, B 32 B 17/04

(54) **Photopolymerisation mittels Carbamoylsulfoxoniumsalzen.**

(30) Priorität: **10.07.80 GB 8022550**
**15.04.81 GB 8111902**

(43) Veröffentlichungstag der Anmeldung: **20.01.82 Patentblatt 82/3**

(45) Bekanntmachung des Hinweises auf die Patenterteilung: **11.09.85 Patentblatt 85/37**

(84) Benannte Vertragsstaaten: **BE CH DE FR GB IT LI NL SE**

(56) Entgegenhaltungen:
**EP - A - 0 022 081**
**AT - B - 287 310**
**DE - A - 2 731 396**
**US - A - 3 442 901**
**US - A - 4 058 401**
**US - A - 4 069 054**

(73) Patentinhaber: **CIBA-GEIGY AG, Postfach, CH-4002 Basel (CH)**

(72) Erfinder: **Green, George Edward, Dr., 18 Church Street, Stapleford Cambridge CB2 5DS (GB)**
Erfinder: **Irving, Edward, Dr., 41, Swaffham Road, Burwell Cambridge CB5 Oan (GB)**

**EP 0 044 274 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

BUNDESDRUCKEREI BERLIN

**Beschreibung**

Die vorliegende Erfindung betrifft Mischungen, die aus einem kationisch polymerisierbaren Material und einem Carbamoylsulfoxoniumsalz bestehen.

Aus verschiedenen Gründen hat es sich als wünschenswert erwiesen, die Polymerisation organischer Materialien mittels aktinischer Strahlung zu induzieren. Bei Anwendung von Photopolymerisationsmethoden kann man beispielsweise die Verwendung organischer Lösungsmittel mit den damit verbundenen Risiken der Giftigkeit, Entflammbarkeit und Umweltverschmutzung und den Kosten der Lösungsmittelrückgewinnung vermeiden. Die Photopolymerisation ermöglicht es, daß nur definierte Stellen der Harzzusammensetzung, d. h. solche, die bestrahlt wurden, unlöslich gemacht werden, und gestattet somit die Herstellung von gedruckten Schaltungen und Druckplatten oder erlaubt es, die Verklebung von Substraten auf die erforderlichen Zonen zu beschränken. Bei Produktionsverfahren sind ferner Bestrahlungsmethoden häufig schneller als solche, die eine Erhitzung und nachfolgende Kühlstufe einschließen.

Es ist seit Jahren bekannt, daß gewisse aromatische Diazoniumsalze bei der Belichtung mit aktinischer Strahlung einer Zersetzung unterliegen und daß, wenn das Salz mit einer kationisch polymerisierbaren Substanz gemischt ist, die bei der Bestrahlung in situ erzeugte Lewissäure dann eine Polymerisation induziert (siehe z. B. GB-Patent 1 321 263). Obwohl die Anwendung von aktinischer Strahlung die mit dem Einsatz von Hitze im Polymerisationsverfahren verbundenen Nachteile überwindet, sind die Diazoniumsalze nicht völlig befriedigend: die Topfzeit des Gemischs aus Diazoniumsalz und kationisch polymerisierbarer Substanz ist häufig zu kurz, insbesondere im Tageslicht, und zweitens entsteht Stickstoff bei der Freisetzung des Lewis-Säurekatalysators, wobei die Gasentwicklung den Verfahrensbereich, in dem die Katalysatoren erfolgreich eingesetzt werden können, beschränkt.

Es wurden deshalb zahlreiche Vorschläge für den Ersatz dieser Diazoniumsalze durch andere Salze gemacht, die bei der Freisetzung eines Säurekatalysators unter Bestrahlung nicht auch Stickstoff entwickeln: die Oniumsalze des Schwefels und Jodoniumsalze wurden besonders intensiv studiert.

So ist es aus dem GB-Patent 1 516 511 und dem äquivalenten US-Patent 4 058 401 bekannt, daß ein Mono-1,2-epoxid, ein Epoxidharz (d. h. eine Substanz, die im Durchschnitt mehr als eine 1,2-Epoxidgruppe enthält) oder deren Gemisch mittels eines strahlungsempfindlichen aromatischen Oniumsalzes des Sauerstoffs, Schwefels, Selens oder Tellurs, das in einer Menge vorliegt, die fähig ist, die Polymerisation oder Härtung des Epoxids (bzw. Polyepoxids) durch Freisetzung eines Brønsted-Säurekatalysators bei der Belichtung mit Strahlungsenergie zu bewirken, polymerisiert oder gehärtet werden kann. Im Britischen Patent 1 518 141 und im US-Patent 4 058 400 wird ferner offenbart, daß monomere oder präpolymere, kationisch polymerisierbare organische Materialien, die frei von 1,2-Epoxidgruppen und unter Vinylmonomeren, Vinylpräpolymeren, cyclischen Äthern, cyclischen Estern, cyclischen Sulfiden, cyclischen Aminen und cyclischen Organosiliciumverbindungen ausgewählt sind, ebenfalls durch Belichtung mit Strahlungsenergie in Gegenwart einer wirksamen Menge eines strahlungsempfindlichen Oniumsalzes der oben angeführten Elemente der Gruppe VI A polymerisiert werden können.

In dem US-Patent 4 102 687 wird offenbart, daß man die Härtung von Harnstoff/Formaldehydharzen, Melamin-Formaldehydharzen und Phenol/Formaldehydharzen durch Belichtung mit ultravioletter Strahlung in Gegenwart eines Oniumsalzes der Gruppe VI A auslösen kann, wobei die Härtung durch Erhitzen vervollständigt wird.

Aus dem GB-Patent 1 535 492 ist die Verwendung strahlungsempfindlicher Sulfoniumsalze von Arylsulfon-, Halogenarylsulfon-, Alkylsulfon- und Halogenoalkylsulfonsäuren für die kationische Polymerisation von Epoxidharzen, Vinylmonomeren und -präpolymeren, cyclischen organischen Äthern, cyclischen organischen Estern, cyclischen organischen Sulfiden, cyclischen Aminen und cyclischen Organosiliciumverbindungen bekannt.

Aus der DE-OS 2 833 648 ist es bekannt, daß man Triarylsulfoniumsalze unter Bestrahlung zur Auslösung der Härtung einer aliphatisch ungesättigten Verbindung, die eine 1,2-Epoxidgruppe enthält, wie Glycidylacrylat, oder eines Gemisches aus einem Epoxidharz mit einer aliphatisch ungesättigten Substanz wie Methylmethacrylat, einem Polyester oder Styrol verwenden kann.

In dem US-Patent 4 136 102 sind verschiedene, ein Hexafluorophosphat-, Hexafluoroarsenat- oder Hexafluoroantimonatanion enthaltende Sulfoniumsalze sowie deren Verwendung bei der Härtung von Epoxidharzen beschrieben. Sie werden auch als nützlich zur Polymerisation einer Reihe nicht näher angegebener cyclischer organischer Verbindungen und cyclischer Organosiliciumverbindungen bezeichnet.

In der belgischen Patentschrift 845 746 wird die Photopolymerisation von Gemischen aus einer Verbindung mit einer Epoxidfunktionalität von mehr als 1,5 Epoxidgruppen pro Molekül und einer Verbindung mit einer Hydroxylfunktionalität von mindestens eins unter Verwendung eines aromatischen Sulfoniumsalzes oder aromatischen Jodoniumsalzes als Katalysator beschrieben.

Das US-Patent 4 090 936 beschreibt licht-härtbare flüssige Zusammensetzungen, die (a) eine organische Verbindung mit einer Durchschnittsepoxidfunktionalität im Bereich von etwa 1 bis 1,3, (b) etwa 3 bis 50 Gew.-%, berechnet auf das Gewicht von (a), eines organischen Polymeren, das mit (a) verträglich ist und einen Glasumwandlungspunkt im Bereich von etwa −20°C bis 105°C aufweist, wobei sich

dieses Polymer von mindestens einem Acrylat- oder Methacrylatmonomer oder einem Copolymer aus Styrol und Allylalkohol oder einem Polyvinylbutyralpolymer ableitet, und (c) einen aromatischen Komplexsalzphotoinitiator, der ein Oniumsalz eines Elements der Gruppe V A oder Gruppe VI A oder ein Haloniumsalz darstellt, enthalten. Die einzigen angegebenen Oniumsalze des Schwefels sind Sulfoniumsalze.

Eine weitere Offenbarung bezüglich des Standes der Technik ist in der US-Patentschrift 4 069 054 enthalten und bezieht sich auf photopolymerisierbare Zusammensetzungen, die ein kationisch-polymerisierbares Monomer, eine aromatische Sulfoniumverbindung und ein aromatisches tertiäres Amin, aromatisches tertiäres Diamin oder eine aromatische polycyclische Verbindung als Sensibilisator enthalten.

Ein aromatisches Sulfoniumsalz, nämlich Triphenylsulfonium-hexafluorophosphat wurde schon industriell zur Photopolymerisation von Epoxidharzen eingesetzt.

Es wurde nun überraschend gefunden, daß man kationisch polymerisierbare Materialien mittels gewisser Arylcarbamoyl- oder Aroylcarbamoylsulfoxoniumsalze photopolymerisieren kann.

Von den zum Stand der Technik gehörenden Sulfoniumsalzen wird auch angegeben, daß sie Katalysatoren zur Heißhärtung oder Hitzepolymerisation seien. Die Carbamoylsulfoxoniumsalze der erfindungsgemäßen Mischungen haben jedoch wenig oder keine Wirkung, wenn sie in Abwesenheit aktinischer Strahlung mit Verbindungen, die unter dem Einfluß eines kationischen Katalysators in höhermolekulares Material überführbar sind, erhitzt werden. So trat bei 40 Stunden Erhitzen auf 150°C keine Gelierung einer 2 Gewichtsteile Acetanilinodimethylsulfoxonium-hexafluorophosphat und 100 Gewichtsteile eines handelsüblichen Epoxidharzes (2,2-Bis-(4-glycidyloxyphenyl)-propan) enthaltenden Mischung ein. Daraus folgt, daß erfindungsgemäße Mischungen wünschenswert lange Topfzeiten besitzen, solange sie vor aktinischer Strahlung geschützt werden.

Im Gegensatz zu den bekannten Sulfoniumsalze als Katalysatoren enthaltenden Mischungen setzen die erfindungsgemäßen Mischungen bei der Bestrahlung keine übelriechenden Mercaptane frei.

Es wurde ferner gefunden, daß Harnstoff-Formaldehydharze entgegen der Lehre des US-Patentes 4 102 687 bei Bestrahlung in Gegenwart eines in den erfindungsgemäßen Mischungen eingesetzten Carbamoylsulfoxoniumsalzes gehärtet werden können, ohne daß Wärmezufuhr nötig wäre.

Gegenstand dieser Erfindung sind demnach Mischungen, welche dadurch gekennzeichnet sind, daß sie enthalten:

(a) eine Verbindung bzw. ein Gemisch von Verbindungen, die unter dem Einfluß eines kationischen Katalysators in höhermolekulares Material überführbar sind, und
(b) als Katalysator eine wirksame Menge eines Carbamoylsulfoxoniumsalzes der Formel VI

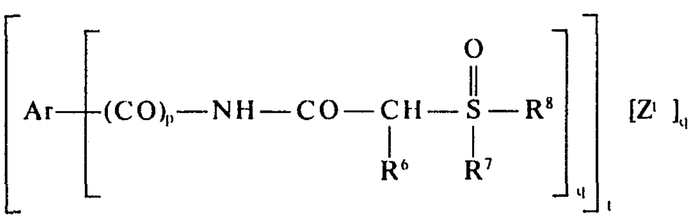

(VI)

worin

p Null oder 1 bedeutet,
q für eine ganze Zahl von 1 bis 4 steht,
Ar einen q-valenten aromatischen Rest darstellt, der 4 bis 25 C-Atome enthält und über eines seiner Kohlenstoffatome direkt an das angegebene Carbonylkohlenstoffatom gebunden ist, wenn $p = 1$ ist, oder wenn $p =$ null ist an das angegebene Stickstoffatom,
$R^6$ ein Wasserstoffatom oder eine Gruppe der Formel VII oder VIII

$-COR^9$ (VII)

oder

$-CONH(CO)_r-R^{10}$ (VIII)

bedeutet,
$R^7$ ein Alkyl mit 1 bis 18 C-Atomen, ein Alkenyl mit 2 bis 6 C-Atomen, ein Cycloalkyl mit 3 bis 8 C-Atomen, ein Cycloalkylalkyl mit 4 bis 10 C-Atomen, ein Aryl mit 4 bis 24 C-Atomen oder ein Aralkyl mit 5 bis 16 C-Atomen bedeutet,
$R^8$ dieselbe Bedeutung wie $R^7$ hat, aber auch für eine Dialkylaminogruppe mit 2 bis 6 C-Atomen oder, falls $R^7$ ein besagtes Alkyl darstellt, auch für eine Arylaminogruppe mit 4 bis 8 C-Atomen stehen kann,

$R^9$ eine monovalente gesättigte oder ethylenisch ungesättigte Gruppe mit 1 bis 12 C-Atomen, die direkt durch ein C-Atom an die Carbonylgruppe der Formel VII gebunden ist, bedeutet,

r gleich null oder 1 ist,

$R^{10}$ eine monovalente gesättigte oder ethylenisch ungesättigte Gruppe mit 1 bis 12 C-Atomen bedeutet, die, wenn r = null ist, direkt über eines ihrer C-Atome an das Stickstoffatom gebunden ist, oder, wenn r für 1 steht, an das Carbonylkohlenstoffatom gebunden ist,

t 1, 2 oder 3 darstellt, und

$Z^{t-}$ ein t-valentes Anion einer Protonensäure, vorzugsweise einer anorganischen Säure, bedeutet, wobei, falls (a) ein 1,2-Epoxid ist, $Z^{t-}$ ein Anion der Formel XI

$$MX_n^- \qquad (XI)$$

worin M für ein Metall oder Metalloidatom und X für ein Halogenatom stehen und n 4, 5 oder 6 und um eins höher als die Wertigkeit von M ist, oder der Formel XII

$$SbF_5(OH)^- \qquad (XII)$$

bedeutet.

In Formel VI können Ar einen homocyclischen oder heterocyclischen Rest, $R^7$ und $R^8$ ein homocyclisches oder heterocyclisches Aryl oder Aralkyl, und $R^8$ kann andererseits für eine homocyclische oder heterocyclische Arylaminogruppierung stehen. Unter »heterocyclisches Aryl«, »heterocyclisches Arylen« oder »heterocyclisches Aralkylen« versteht man eine aromatische Gruppe, in der mindestens eine $-CH_2$- oder $-CH$-Gruppe eines Rings einer aromatischen Verbindung durch ein von Kohlenstoff verschiedenes Atom, üblicherweise Stickstoff, Sauerstoff oder Schwefel, ersetzt ist.

Beispiele für heterocyclische Arylgruppen sind 2-Furylreste und 2-Pyridylreste, und heterocyclische Arylengruppen sind beispielsweise Furan-2,4-diyl- und Pyridin-2,6-diylreste.

So kann Ar einen homocyclischen Rest bedeuten, beispielsweise einen tricyclischen Rest, wie ein Anthryl, Phenanthryl, Fluorenyl oder eine Anthrylen-, Phenanthrylen- oder Fluorenylengruppe, doch steht Ar vorzugsweise für

i) ein mono- oder dicyclisches Aryl oder Aralkyl mit 6 bis 16 C-Atomen, insbesondere ein Phenyl, 2-Phenyläthyl, Benzyl, Naphthyl oder eine Gruppe der Formel IX

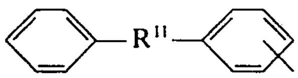

(IX)

worin

$R^{11}$ eine C—C-Bindung, ein Äthersauerstoffatom oder einen Rest der Formel $-CH_2-$ oder $-C(CH_3)_2-$ bedeuten,

ii) ein mono- oder dicyclisches Arylen oder Aralkylen mit 6 bis 16 C-Atomen, insbesondere ein Phenylen, Phenylenmethylen, ($-C_6H_4CH_2-$), ein Naphthylen oder einen Rest der Formel X

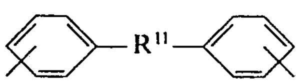

(X)

worin

$R^{11}$ die gleiche Bedeutung wie in Formel IX hat, und wobei das Aryl, Aralkyl, Arylen oder Aralkylen am aromatischen Ring durch 1 bis 3 Chlor-, Fluor- oder Bromatome, 1 bis 3 Alkylgruppen mit 1 bis 4 C-Atomen oder durch 1 bis 3 Alkoxygruppen mit 1 bis 4 C-Atomen substituiert sein kann.

Als geeignete Reste Ar seien beispielsweise genannt: Phenyl, p-Chlorphenyl, 3,4-Dichlorphenyl, o-Tolyl, p-Tolyl, p-Methoxyphenyl, 2,4-Toluylen, 2,6-Toluylen, Benzyl, 2-Phenylethyl, o-, m- und p-Phenylen, p-Phenylenmethylen und Methylen-bis-(phenylen).

$R^7$ und $R^8$ bedeuten vorzugsweise ein Alkyl mit 1 bis 4 C-Atomen oder ein Phenyl oder Naphthyl, welche am aromatischen Ring 1 bis 2 Alkylgruppen mit je 1 bis 4 C-Atomen, 1 bis 2 Alkoxygruppen mit je 1 bis 4 C-Atomen oder 1 bis 2 Fluor-, Chlor- oder Bromatome aufweisen können. Insbesondere bedeuten $R^7$ und $R^8$ je eine Methylgruppe.

$R^9$ und $R^{10}$ bedeuten vorzugsweise je eine aliphatische Gruppe mit 1 bis 8 C-Atomen, insbesondere ein Alkyl oder Alkenyl mit 1 bis 6 C-Atomen, welche mit 1 bis 3 Chlor-, Fluor- oder Bromatomen substituiert sein können oder in der aliphatischen Kette Sauerstoffatome enthalten können.

Als Beispiele für geeignete $R^9$- und $R^{10}$-Gruppen seien Methyl, Ethyl und 2-Ethoxyethyl genannt.

$Z^{t-}$ kann beispielsweise $CH_3SO_4-$ bedeuten, aber vorzugsweise bedeutet es $Cl^-$, $Br^-$, $NO_3^-$, $HSO_4^-$, $HSO_3^-$, $ClO_4^-$, $CF_3SO_3^-$, $CF_3COO^-$, $C_6H_5SO_3^-$, $CH_3C_6H_4SO_3^-$, $H_2PO_4$, $SO_4^{--}$, $PO_4^{---}$, ein Anion der Formel XI

$MX_n^-$ (XI)

worin M für ein Metall oder Metalloidatom und X für ein Halogenatom, vorzugsweise Fluor oder Chlor, stehen und n 4, 5 oder 6 und um eins höher als die Wertigkeit von M ist, oder der Formel XII

$SbF_5(OH)^-$ (XII)

M bedeutet vorzugsweise ein Bor- oder Wismut- und ganz besonders ein Antimon-, Arsen- oder Phosphoratom. Als Anion(en) $MX_n^-$ können also beispielsweise $BiCl_6^-$ oder $BF_4^-$, aber besonders bevorzugt $PF_6^-$, $SbF_6^-$ oder $AsF_6^-$ vorliegen.

Die Sulfoxoniumsalze der Formel VI können nach dem folgenden Verfahren hergestellt werden:

1. Solche, in denen p null ist und $R^6$ ein Wasserstoffatom bedeutet, sind durch Umsetzung eines aromatischen Isocyanats der Formel XIII

   $Ar(NCO)_q$ (XIII)

   mit äquimolaren Mengen eines Oxosulfoniumylids der Formel XIV

   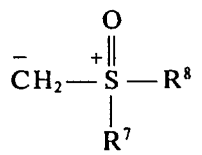
   (XIV)

   erhältlich, wobei Carbamoylylide der Formel XV

   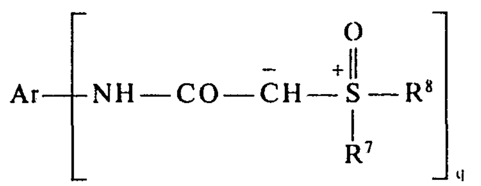
   (XV)

   entstehen, die anschließend mit q/t molaren Mengen einer Protonensäure der Formel $H_tZ$, zum Beispiel Salz-, Phosphor-, Tetrafluorobor-, Hexafluorophosphor-, Orthophosphor- oder Salpetersäure, neutralisiert werden. Vorzugsweise setzt man das Ylid der Formel XIV dabei im Überschuß ein.

   Oxosulfoniumylide der Formel XIV sind zugänglich, indem man Sulfoxoniumjodide der Formel XVI

   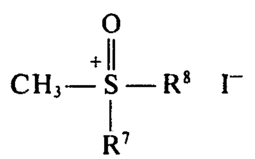
   (XVI)

   mit starken Basen, wie Natriumhydrid, behandelt (E. J. Corey and M. Chaykovsky, J.Amer.Soc., 1962, 84, 867). Die Reaktion solcher Ylide mit Aryl- und Aralkylisocyanaten wird von H. König und H. Metzger in Chem. Ber. 1965, 98, Seite 3733–3747 beschrieben.
2. Sulfoxoniumsalze der Formel VI, worin p null ist und $R^6$ eine Gruppe der Formel VII bedeutet, können durch Umsetzung eines Ylides der Formel XV mit einem Acylierungsmittel, wobei eine Gruppe der Formel $-COR^9$ eingeführt wird, wie zum Beispiel Acylchlorid, und anschließende Neutralisation mit q/t molaren Mengen einer Protonensäure der Formel $H_tZ$ erhalten werden.

   Derartige Acylierung eines Carbamoylylids ist beispielsweise im US-Patent 3 442 901 beschrieben.
3. Sulfoxoniumsalze der Formel VI, worin p null ist und $R^6$ eine Gruppierung der Formel VIII bedeutet, können durch Umsetzung eines Ylids der Formel XV mit äquimolaren Mengen eines Isocyanats der Formel $R^{10}[(CO)_rNCO]_9$ erhalten werden, wobei die entstehenden Bis(carbamoyloxosulfoniumylide) der Formel XVII

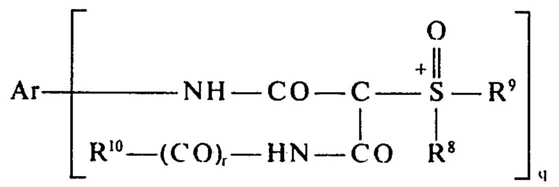

(XVII)

anschließend mit q/t molaren Mengen einer Protonensäure der Formel $H_tZ$ neutralisiert werden.

4. Sulfoxoniumsalze der Formel VI, worin p für 1 und r für null oder 1 stehen, können in ähnlicher Weise aus einem Aracylisocyanat der Formel $Ar(CONCO)_9$ und einem Isocyanat der Formel $R^{10}[(CO)_rNCO]_q$ erhalten werden. Die Reaktion des Acylisocyanats mit Dimethyloxosulfoniummethylid wird von O. Tsuge et al., in Tetrahedron, 1973, 29, Seite 1983—1990 beschrieben.

Wo eine bestimmte Protonensäure $H_tZ$ nicht zur Verfügung steht oder schwierig zu handhaben ist, kann man Salze wie Hexafluorophosphate und Hexafluoroantimonate durch doppelte Umsetzung mit den entsprechenden Chloriden oder anderen geeigneten Salzen herstellen. Beispielsweise kann man Acetanilinodimethylsulfoxoniumhexafluorophosphat durch Ausfällen beim Zusatz einer wäßrigen Lösung von Kalium-hexafluorophosphat zu einer wäßrigen Lösung des Chlorids erhalten. Die Hexafluoroantimonate können durch Zugabe von festem Kalium-hexafluoroantimonat zu einer wäßrigen Lösung des Sulfoxoniumchlorids hergestellt werden; löst man das Kalium-hexafluoroantimonat zunächst in Wasser, so ist das isolierte Produkt dann wegen Hydrolyse das Hydroxopentafluoroantimonat ($Z^t = SbF_5(OH)^-$).

Bestimmte Beispiele für geeignete Carbamoylsulfoxoniumsalze sind:

Acetanilinodimethylsulfoxonium-hexafluorophosphat und das entsprechende Hexafluoroarsenat,
3,4-Dichloroacetanilinodimethylsulfoxonium-hexafluoroarsenat,
p-Methylacetanilinodimethylsulfoxonium-hexafluorophosphat,
p-Methylacetanilinodimethylsulfoxonium-chlorid,
Benzoylcarbamoyldimethylsulfoxonium-hexafluorophosphat,
p-Chloracetanilinodimethylsulfoxonium-hexafluorophosphat,
2,4-Bis-(dimethylsulfoxoniummethylcarbamoyl)-toluol-dihexafluorophosphat und
Tris-(acetanilinodimethylsulfoxonium)-orthophosphat.

Die Salze der Formel VI, worin $Z^t$ ein Anion der Formel XI oder XII bedeutet, stellen neue Verbindungen dar.

Die erfindungsgemäßen Mischungen enthalten vorzugsweise 0,1 bis 7,5, insbesondere 0,5 bis 5,0 Gewichtsteile (b) per 100 Gewichtsteile (a).

Die Komponente (a) kann beispielsweise ein Oxetan, ein Thi-iran oder ein Tetrahydrofuran sein. Vorzugsweise ist dies ein 1,2-Epoxid, ein Vinylmonomer oder -präpolymer, ein Aminoplast oder ein Phenoplast.

Als Komponente (a) kann beispielsweise ein Mono-1,2-epoxid, wie Epichlorhydrin, Propylenoxid oder ein Glycidyläther eines einwertigen Alkohols oder Phenols, wie n-Butylglycidyläther oder Phenylglycidyläther, vorliegen; dies kann auch z. B. ein Glycidylester wie Glycidylacrylat oder Glycidylmethacrylat sein. Vorzugsweise ist es ein Epoxidharz, insbesondere ein solches, das mindestens eine direkt an ein Sauerstoffatom gebundene Gruppe der Formel XVIII

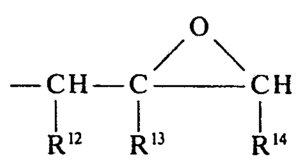

(XVIII)

enthält, worin entweder $R^{12}$ und $R^{14}$ je ein Wasserstoffatom darstellen, in welchem Fall $R^{13}$ ein Wasserstoffatom oder eine Methylgruppe bedeutet, oder $R^{12}$ und $R^{14}$ zusammen $-CH_2CH_2-$ darstellen, in welchem Fall $R^{13}$ ein Wasserstoffatom bedeutet.

Als Beispiele für solche Harze seien Polyglycidyl- und Poly-($\beta$-methylglycidyl)-ester genannt, die man durch Umsetzung einer zwei oder mehr Carbonsäuregruppen pro Molekül enthaltenden Verbindung mit Epichlorhydrin, Glycerin-dichlorhydrin oder $\beta$-Methylepichlorhydrin in Gegenwart von Alkali erhalten kann. Solche Polyglycidylester können sich von aliphatischen Polycarbonsäuren, z. B. Bernsteinsäure, Glutarsäure, Adipinsäure, Pimelinsäure, Korksäure, Azelainsäure, Sebacinsäure oder dimerisierter oder trimerisierter Linolsäure, von cycloaliphatischen Polycarbonsäuren wie Tetrahydrophthalsäure, 4-Methyltetrahydrophthalsäure, Hexahydrophthalsäure und 4-Methylhexahydrophthalsäure und von aromatischen Polycarbonsäuren wie Phthalsäure, Isophthalsäure und Terephthalsäure ableiten. Weitere geeignete Polyglycidylester sind durch Polymerisation der Glycidylester von Vinylsäuren, insbesondere Glycidylacrylat und Glycidylmethacrylat, erhältlich.

Weitere Beispiele sind Polyglycidyl- und Poly-(β-methylglycidyl)-äther, die durch Umsetzung einer mindestens zwei freie alkoholische und/oder phenolische Hydroxylgruppen pro Molekül enthaltenden Verbindung mit dem entsprechenden Epichlorhydrin unter alkalischen Bedingungen, oder auch in Gegenwart eines sauren Katalysators mit nachfolgender Alkalibehandlung erhältlich sind. Diese Äther lassen sich mit Poly-(epichlorhydrin) aus acyclischen Alkoholen wie Äthylenglykol, Diethylenglykol und höheren Poly-(oxyethylen)-glykolen, Propan-1,2-diol und Poly-(oxypropylen)-glykolen, Propan-1,3-diol, Poly-(oxytetramethylen)-glykolen, Pentan-1,5-diol, Hexan-2,4,6-triol, Glycerin, 1,1,1-Trimethylolpropan, Pentaerythrit und Sorbit, aus cycloaliphatischen Alkoholen wie Resorcit, Chinit, Bis-(4-hydroxycyclohexyl)-methan, 2,2-Bis-(4-hydroxycyclohexyl)-propan und 1,1-Bis-(hydroxymethyl)-cyclohexen-3, sowie aus Alkoholen mit aromatischen Kernen, wie N,N-Bis-(2-hydroxyäthyl)-anilin und p,p'-Bis-(2-hydroxyäthylamino)-diphenylmethan, herstellen. Man kann sie ferner aus einkernigen Phenolen wie Bis-(4-hydroxyphenyl)-methan (sonst als Bisphenol F bekannt), 4,4'-Dihydroxyphenyl, Bis-(4-hydroxyphenyl)-sulfon, 1,1,2,2-Tetrakis-(4-hydroxyphenyl)-äthan, 2,2-Bis-(4-hydroxyphenyl)-propan (Bisphenol A) und 2,2-Bis-(3,5-dibrom-4-hydroxyphenyl)-propan, sowie aus Aldehyden wie Formaldehyd, Acetaldehyd, Chloral und Furfurol mit Phenol selbst und durch Chloratome oder Alkylgruppen mit jeweils bis zu neun Kohlenstoffatomen ringsubstituiertes Phenol, wie 4-Chlorphenol, 2-Methylphenol und 4-tert.-Butylphenol, gebildeten Novolaken herstellen.

Poly-(N-glycidyl)-verbindungen lassen sich ebenfalls verwenden, beispielsweise N-Glycidylderivate von Aminen wie Anilin, n-Butylamin, Bis-(4-aminophenyl)-methan und Bis-(4-methylaminophenyl)-methan, Triglycidylisocyanurat sowie N,N'-Diglycidylderivate von cyclischen Alkylenharnstoffen wie Äthylenharnstoff und 1,3-Propylenharnstoff, und Hydantoinen wie 5,5'-Dimethylhydantoin. Im allgemeinen sind diese jedoch nicht bevorzugt.

Ebenfalls kann man Poly-(S-glycidyl)-verbindungen einsetzen, z. B. Di-(S-glycidyl)-derivate von Dithiolen wie Äthan-1,2-dithiol und Bis-(4-mercaptomethylphenyl)-äther, doch werden auch diese nicht bevorzugt.

Beispiele für Epoxidharze mit Gruppen der Formel XVIII, worin $R^{12}$ und $R^{14}$ zusammen eine $-CH_2CH_2-$ Gruppe bedeuten, sind Bis-(2,3-epoxycyclopentyl)-äther, 2,3-Epoxycyclopentyl-glycidyläther und 1,2-Bis-(2,3-epoxycyclopentyloxy)-äthan.

In Betracht kommen auch Epoxidharze, in denen die 1,2-Epoxidgruppen an Heteroatome verschiedener Art gebunden sind, z. B. der Glycidyläther/Glycidylester der Salicylsäure.

Ebenfalls verwendbar sind Epoxidharze, in denen einige oder sämtliche Epoxidgruppen mittelständig sind, wie Vinylcyclohexendioxyd, Limonendioxyd, Dicyclopentadiendioxyd, 4-Oxatetracyclo-[6.2.1.$0^{2,7}$.$0^{3,5}$]undecyl-9-glycidyläther, 1,2-Bis-(4-oxatetracyclo[6.2.1.$0^{2,7}$.$0^{3,5}$]undecyl-9-oxy)-äthan, der 3,4-Epoxycyclohexylmethylester der 3',4'-Epoxycyclohexancarbonsäure sowie dessen 6,6'-Dimethylderivat, der Bis-(3,4-epoxycyclohexancarbonsäureester) des Äthylenglykols, 3-(3,4-epoxy-cyclohexyl)-8,9-epoxy-2,4-dioxaspiro[5.5]-undecan sowie epoxidierte Butadiene oder Copolymere des Butadiens mit Äthylenverbindungen wie Styrol und Vinylacetat.

Gewünschtenfalls kann man Epoxidharzgemische verwenden.

Besonders bevorzugte, in der erfindungsgemäßen Mischung verwendete, gegebenenfalls vorverlängerte Epoxidharze sind die Diglycidyläther von zweiwertigen Phenolen, wie 2,2-Bis-(4-hydroxyphenyl)-propan und Bis-(4-hydroxyphenyl)-methan, und von zweiwertigen aliphatischen Alkoholen wie Butan-1,4-diol.

Gewünschtenfalls kann man das Epoxidharz einer Mischhärtung mit einem mehrwertigen Alkohol, d. h. einer Verbindung mit mindestens zwei alkoholischen, vorzugsweise primären Hydroxylgruppen im Molekül, unterwerfen. Vorzugsweise liegt der mehrwertige Alkohol in genügender Menge vor, um 0,5 bis 1,5, insbesondere 0,75 bis 1,25, alkoholische Hydroxylgruppen pro 1,2-Epoxidgruppe des Epoxidharzes zu liefern. Der mehrwertige Alkohol enthält vorzugsweise außer den alkoholischen Hydroxylgruppen nur Kohlenstoff-, Wasserstoff- und gegebenenfalls als Äthersauerstoff oder Acetal- oder Carbonylgruppen vorhandene Sauerstoff- sowie Halogenatome. Ferner besitzt der mehrwertige Alkohol vorzugsweise ein Molekulargewicht von mindestens 100 und insbesondere höher als 1000. Geeignete mehrwertige Alkohole sind beispielsweise Poly-(oxyäthylen)-glykole, Poly-(oxypropylen)-glykole, Poly-(oxytetramethylen)-glykole, Polyepichlorhydrine, Poly-(oxyäthylen)-, Poly-(oxypropylen)-, bzw. Poly-(oxytetramethylen)-triole, die durch Polymerisation von Äthylenoxid, Propylenoxid bzw. Tetrahydrofuran in Gegenwart von Glycerin oder 1,1,1-Trimethylolpropan erhältlich sind, Polycaprolactone mit Hydroxylendgruppen, Copolymere des Styrols mit Allylalkohol, Polyvinylalkohole, Hydroxypropylcellulose, hydroxyhaltige Polyvinylacetale und Teilester der Cellulose, z. B. ein Celluloseacetatbutyrat.

Vinylmonomere und -präpolymere, die dabei polymerisiert werden können, sind unter anderem Styrol, α-Methylstyrol, Allylbenzol, Divinylbenzol, Vinylcyclohexan, 4-Vinylcyclohexen-1, N-Vinylpyrrolidinon-2, N-Vinylcarbazol, Acrolein, Isopren, Butadien, Piperylen, Vinylacetat und Vinyläther wie Isobutylvinyläther, Methylvinyläther, Trimethylolpropan-trivinyläther, Glycerintrivinyläther, die Vinyläther von Äthylenglykol und Poly-(oxyäthylenglykolen) und cyclische Vinyläther mit mindestens zwei cyclischen Vinyläthergruppen, die jeweils einen Teil eines 3,4-Dihydro-2H-pyrankerns bilden, wie der 3,4-Dihydro-2H-pyranyl-(2)-methylester der 3,4-Dihydro-2H-pyran-2-carbonsäure und dessen Präpolymere. Die bevorzugten Vinylverbindungen sind Vinyläther von aliphatischen einwertigen Alkoholen mit 1 bis 4 Kohlenstoffatomen sowie der 3,4-Dihydro-2H-pyranyl-(2)-methylester der 3,4-Dihydro-2H-pyran-2-carbonsäure und dessen Präpolymere.

Die als Komponente (a) bevorzugten Aminoplaste enthalten pro Molekül mindestens zwei direkt an ein Amid- oder Thioamidstickstoffatom bzw. -atome gebundene Gruppen der Formel $-CH_2OR^{15}$, worin $R^{15}$ ein Wasserstoffatom, eine Alkylgruppe mit 1 bis 4 Kohlenstoffatomen oder eine Acetylgruppe bedeutet. Beispiele für solche Aminoplaste sind die N-Hydroxymethyl-, N-Methoxymethyl-, N-Butoxymethyl- und N-Acetoxymethylderivate der folgenden Amide und amidartigen Substanzen:

I. Harnstoff, Thioharnstoff und cyclische Harnstoffe der Formel XIX

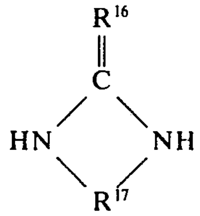

(XIX)

worin $R^{16}$ Sauerstoff oder Schwefel und $R^{17}$ entweder eine Gruppe der Formel XX

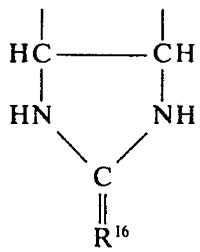

(XX)

oder eine gegebenenfalls durch Methyl-, Methoxy- oder Hydroxylgruppen substituierte und gegebenenfalls durch $-CO-$, $-O-$ oder $-N(R^{18})-$, wobei $R^{18}$ für eine Alkyl- oder Hydroxyalkylgruppe mit bis zu 4 Kohlenstoffatomen steht, unterbrochene zweiwertige Gruppe mit 2 bis 4 Kohlenstoffatomen darstellen.

Solche cyclischen Harnstoffe sind beispielsweise Ethylenharnstoff (Imidazolidinon-2), Dihydroxyethylenharnstoff (4,5-Dihydroxyimidazolidinon-2), Hydantoin, Uron (Tetrahydro-oxadiazinon-4), 1,2-Propylenharnstoff (4-Methylimidazolidinon-2), 1,3-Propylenharnstoff (Hexahydro-2H-pyrimidon-2), Hydroxypropylenharnstoff (5-Hydroxyhexahydro-2H-pyrimidon-2), Dimethylpropylenharnstoff (5,5-Dimethylhexahydro-2H-pyrimidon-2), Dimethylhydroxypropylenharnstoff bzw. Dimethylmethoxypropylenharnstoff (4-Hydroxy- bzw. 4-Methoxy-5,5-dimethylhexahydro-2H-pyrimidon-2), 5-Äthyltriazinon-2 und 5-(2-Hydroxyethyl)-triazinon-2.

II. Carbamate und Dicarbamate aliphatischer einwertiger und zweiwertiger Alkohole mit bis zu vier Kohlenstoffatomen, z. B. Methyl-, Ethyl-, Isopropyl-, 2-Hydroxyethyl-, 2-Methoxyethyl-, 2-Hydroxy-n-propyl- und 3-Hydroxy-n-propylcarbamate sowie Ethylen- und 1,4-Butylendicarbamate.

III. Melamin und weitere Polyamino-1,3-triazine wie Acetoguanamin, Benzoguanamin und Adipoguanamin.

Gewünschtenfalls kann man Aminoplaste einsetzen, die sowohl N-Hydroxymethyl- als auch N-Alkoxymethyl- oder N-Hydroxymethyl- und N-Acetoxymethylgruppen enthalten (beispielsweise ein Hexamethylolmelamin, in dem 1 bis 3 Hydroxylgruppen mit Methylgruppen veräthert sind).

Die bevorzugten Aminoplaste sind Kondensationsprodukte des Harnstoffs, Urons, Hydantoins oder Melamins mit Formaldehyd sowie teilweise oder völlig verätherte Produkte solcher Kondensationsprodukte mit einem aliphatischen einwertigen Alkohol mit 1 bis 4 Kohlenstoffatomen. Spezielle Beispiele für geeignete Aminoplaste sind Hexamethoxymethylmelamin und ein Kondensationsprodukt aus Harnstoff mit 1,8 Mol Formaldehyd.

Als Phenoplaste werden aus einem Phenol und einem Aldehyd hergestellte Resole bevorzugt. Als Phenole eignen sich unter anderem Phenol selbst, Resorcin, 2,2-Bis-(p-hydroxyphenyl)-propan, p-Chlorphenol, ein durch ein oder zwei Alkylgruppen mit jeweils 1 bis 9 Kohlenstoffatomen substituiertes Phenol, wie o-, m- und p-Kresol, die Xylenole, p-tertiär-Butylphenol, p-Nonylphenol und phenyl-substituierte Phenole, insbesondere p-Phenylphenol. Der mit dem Phenol kondensierte Aldehyd ist vorzugsweise Formaldehyd, doch kommen auch andere Aldehyde wie Acetaldehyd und Furfurol in Frage. Gewünschtenfalls kann man ein Gemisch aus solchen härtbaren Phenol/Aldehydharzen verwenden.

Die bevorzugten Resole sind Kondensationsprodukte des Phenols, p-Chlorphenols, Resorcins oder o-, m- oder p-Kresols mit Formaldehyd.

Vorzugsweise enthalten die erfindungsgemäßen Zusammensetzungen auch einen Sensibilisator. Es wurde gefunden, daß die Einarbeitung geeigneter Sensibilisatoren die Härtungsgeschwindigkeit noch

weiter steigert, was die Anwendung noch kürzerer Belichtungszeiten und/oder weniger starker Bestrahlungsquellen ermöglicht. Außerdem wird die Empfindlichkeit für sichtbares Licht erhöht. Von Farbstoffen verschiedene Sensibilisatoren haben sich als wirksamer erwiesen, insbesondere aromatische polycyclische Verbindungen mit mindestens drei kondensierten Benzolringen und mit einer Ionisationsenergie unter etwa 7,5 eV. Geeignete Sensibilisatoren dieser Art sind in der US-Patentschrift Nr. 4 069 054 beschrieben und schließen Anthracen, Rubran, Perylen, Phenanthren, Fluoranthen und Pyren ein.

Vorzugsweise arbeitet man 0,1 bis 2% und insbesondere 0,25 bis 0,75 Gew.-% des Sensibilisators, berechnet auf das Gewicht von (a), ein.

Beim Photopolymerisationsvorgang verwendet man vorzugsweise aktinische Strahlung einer Wellenlänge von 200 bis 600 nm. Als aktinische Strahlungsquellen eignen sich unter anderem Kohlelichtbögen, Quecksilberdampflichtbögen, Leuchtröhren mit ultraviolettes Licht ausstrahlenden Leuchtstoffen, Argon- und Xenonglimmlampen, Wolframlampen und photographische Flutlampen. Darunter sind Quecksilberdampflichtbögen, insbesondere Höhensonnen, fluoreszierende Höhensonnen und Metallhalogenidlampen am besten geeignet. Die zur Belichtung erforderliche Zeit wird von verschiedenen Faktoren abhängen, unter anderem beispielsweise dem jeweils verwendeten polymerisierbaren Substrat, der Art der Lichtquelle und deren Abstand vom bestrahlten Material. Der mit Photopolymerisationsmethoden vertraute Fachmann kann die geeigneten Zeiten leicht bestimmen. Wenn es wie in dem unten beschriebenen Verfahren erforderlich ist, daß das so photopolymerisierte Produkt beim Erhitzen mit einem eingemischten Heißhärter noch härtbar ist, dann muß die Bestrahlung natürlich bei einer Temperatur unterhalb derjenigen, bei der weitgehende Heißhärtung des photopolymerisierten Produkts durch den Heißhärter eintreten würde, erfolgen.

Die erfindungsgemäßen Mischungen sind als Oberflächenbeschichtungen verwendbar. Man kann sie, vorzugsweise als Flüssigkeit, auf ein Substrat wie Stahl, Aluminium, Kupfer, Cadmium, Zink, Papier oder Holz aufbringen und bestrahlen. Polymerisiert man einen Teil der Beschichtung, wie bei Bestrahlung durch eine Maske hindurch, so kann man die unbelichteten Stellen mit einem Lösungsmittel waschen, um unpolymerisierte Anteile zu entfernen, während die photopolymerisierten, unlöslichen Anteile an Ort und Stelle verbleiben. Die erfindungsgemäßen Zusammensetzungen sind somit bei der Herstellung von Druckplatten und gedruckten Schaltungen verwendbar. Methoden zur Herstellung von Druckplatten und gedruckten Schaltungen aus photopolymerisierbaren Mischungen sind wohlbekannt (siehe z. B. britische Patentschrift Nr. 1 495 746).

Die Mischungen lassen sich auch als Klebstoffe verwenden. Eine Schicht der Zusammensetzung kann zwischen zwei Oberflächen von Gegenständen, von denen mindestens einer für aktinische Strahlung durchlässig ist, z. B. Glas, eingebracht werden, und der Aufbau wird dann bestrahlt und gewünschtenfalls erhitzt, um die Polymerisation zu vervollständigen.

Die Mischungen sind ferner bei der Herstellung von faserverstärkten Verbundstoffen, einschließlich Plattenpreßmassen, verwendbar. Dabei kann man sie in flüssiger Form direkt auf Verstärkungsfasern (einschließlich Spinnfäden, Endlosfäden und Whiskers) auftragen, die in Form von Gewebe- oder Faservlies, kettenstarken Schnitten oder Stapelseide vorliegen, insbesondere von Fasern aus Glas, Bor, Edelstahl, Wolfram, Aluminiumoxid, Siliciumcarbid, Asbest, Kaliumtitanatwhiskers, einem aromatischen Polyamid wie Poly-(m-phenylenisophthalamid), Poly-(p-phenylenterephthalamid) oder Poly-(p-benzamid), Polyäthylen, Polypropylen oder Kohlenstoff.

Der faserverstärkte Verbundstoff kann nach einem diskontinuierlichen Verfahren hergestellt werden, indem man das faserförmige Verstärkungsmaterial auf eine Folie aus photopolymerisierter Zusammensetzung, die zweckmäßigerweise etwas unter Spannung steht, auflegt und wenn erwünscht eine zweite solche Folie darüberlegt, und dann den Aufbau unter Erhitzen verpreßt. Auch ist kontinuierliche Herstellung dadurch möglich, daß man das faserförmige Verstärkungsmaterial mit der Folie aus photopolymerisierter Zusammensetzung in Berührung bringt und dann gewünschtenfalls eine zweite solche Folie auf die Rückseite des faserförmigen Verstärkungsmaterials legt und Hitze und Druck zur Einwirkung bringt. Zweckmäßiger bringt man zwei solche, vorzugsweise auf der Rückseite durch Bänder oder abziehbare Blätter abgestützte Folien gleichzeitig auf das faserförmige Verstärkungsmaterial so auf, daß die beiden freiliegenden Seiten in Berührung kommen. Werden zwei solche Folien aufgebracht, so können diese gleich oder verschieden sein.

Vielschichtige Verbundstoffe lassen sich dadurch herstellen, daß man abwechselnde Folien und Schichten aus einem oder mehreren faserförmigen Verstärkungsmaterialien unter Druck erhitzt. Bei Verwendung kettenstarker Fasern als Verstärkungsmaterial können deren aufeinanderfolgende Schichten so orientiert sein, daß sich gekreuzte Lagen ergeben.

Gegebenenfalls kann man mit dem faserförmigen Verstärkungsmaterial zusätzliche Verstärkungstypen wie eine Metallfolie (z. B. aus Aluminium, Stahl oder Titan) oder eine Kunststoffolie (aus einem aromatischen oder aliphatischen Polyamid, Polyimid, Polysulfon oder Polycarbonat) oder Kautschukfolie (z. B. aus Neopren oder Acrylnitrilkautschuk) verwenden.

Bei der Herstellung von Plattenpreßmassen wird eine erfindungsgemäße Mischung mit dem Stapelseideverstärkungsmaterial und gegebenenfalls weiteren Komponenten schichtweise einer Bestrahlung durch Trägerfolien hindurch ausgesetzt.

Von der polymerisierbaren Mischung wird vorzugsweise so viel eingesetzt, daß der Verbundstoff

insgesamt 20 bis 80 Gew.-% dieser Mischung und dementsprechend 80 bis 20 Gew.-% Verstärkung enthält. Besonders bevorzugt verwendet man 30 bis 50 Gew.-% der Mischung.

Die erfindungsgemäßen Mischungen sind zur Herstellung von Kitten und Spachtelmassen verwendbar. Sie lassen sich als Tauchbeschichtungen anwenden, wobei ein zu beschichtender Artikel in die flüssige Zusammensetzung getaucht und wieder entnommen und die anhaftende Beschichtung zur Photopolymerisation und damit Verfestigung bestrahlt und gewünschtenfalls anschließend erhitzt wird.

Es wurde gefunden, daß es möglich ist, unter Verwendung der erfindungsgemäßen Mischung Epoxidharze und Phenoplaste in zwei Stufen zu härten; zunächst wird das Harz durch Belichtung mit aktinischer Strahlung in Gegenwart eines Carbamoylsulfoxoniumsalzes und eines latenten, hitzeaktivierbaren Vernetzungsmittels für das Epoxidharz oder Phenoplast in die teilweise gehärtete B-Stufe umgewandelt, und in einer zweiten Stufe wird die teilweise gehärtete Mischung so erhitzt, daß die Härtung mittels des hitzeaktivierbaren Vernetzungsmittels zuendegeht. So kann man eine flüssige oder halbflüssige Mischung herstellen, die dann geformt oder zur Imprägnierung eines Substrats verwendet werden kann, während sie zur Verfestigung bestrahlt wird; der verfestigte Körper wird dann zur gewünschten Zeit erhitzt, um die Härtung des Harzes zu vervollständigen.

Gemäß einer weiteren Ausführungsform dieser Erfindung wird daher ein Epoxidharz oder ein Phenoplast in Gegenwart einer zur Polymerisation des Epoxidharzes oder Phenoplastes wirksamen Menge eines Carbamoylsulfoxoniumsalzes der Formel VI und einer härtenden Menge eines latenten Heißhärters für das Epoxidharz oder Phenoplast unter Bildung des B-Stufenprodukts bestrahlt, und die Härtung der Zusammensetzung wird zur gewünschten Zeit durch Erhitzen vervollständigt.

Eine weitere Ausführungsform umfaßt eine Mischung, die ein Epoxidharz oder Phenoplast, eine zur Polymerisation dieses Epoxidharzes oder Phenoplastes bei Belichtung der Mischung mit aktinischer Strahlung wirksame Menge eines Carbamoylsulfoxoniumsalzes der Formel VI und eine härtende Menge eines latenten Heißhärters für das Epoxidharz oder Phenoplast enthält.

Als hitzeaktivierbare Vernetzungsmittel für Epoxidharze eignen sich unter anderem Polycarbonsäureanhydride, Komplexe von Aminen, insbesondere primären oder tertiären aliphatischen Aminen wie Ethylamin, Trimethylamin und n-Octyldimethylamin mit Bortrifluorid oder Bortrichlorid, und latente Bordifluoridchelate. Aromatische Polyamine und Imidazole sind im allgemeinen nicht bevorzugt, da sie ziemlich schlechte Resultate ergeben, möglicherweise wegen einer Reaktion zwischen dem freigesetzten sauren Katalysator und dem Amin. Dicyandiamid kann mit Erfolg verwendet werden, solange es in Form relativ grober Teilchen vorliegt.

Geeignete hitzeaktivierbare Vernetzungsmittel für Resole sind unter anderem Hexamethylentetramin und Paraform.

Die für die Heißhärtung erforderliche Temperatur und Erhitzungsdauer sowie die Anteile an hitzeaktivierbarem Härter werden leicht durch Reihenversuche ermittelt und lassen sich ohne weiteres aus dem wohlbekannten Fachwissen über die Heißhärtung von Epoxidharzen und Phenol/Aldehydresolen ableiten.

Aufgrund dessen, daß die in den Mischungen enthaltenen Verbindungen Gruppen aufweisen, über die sie nach der Photopolymerisation heißgehärtet werden können, sind sie besonders bei der Herstellung von mehrlagigen gedruckten Schaltungen nützlich.

Herkömmlicherweise wird eine mehrlagige gedruckte Schaltung aus mehreren zweiseitigen Kupferleiterplatten hergestellt, die übereinander gestapelt und gegenseitig durch Isolierbögen, üblicherweise aus mit einem Epoxidharz oder Phenol-Formaldehydharz in der B-Stufe imprägnierter Glasfaser, getrennt werden. Wird kein Heißhärter in die photopolymerisierbare Harzschicht in der Leiterplatte eingemischt, so kann man sie in die mit den Platten alternierenden Isolierschichten einbringen, welche zweckmäßig aus einem Epoxidharz- oder Phenol/Formaldehydharzprepreg bestehen; vorausgesetzt, der Prepreg ist nicht zu dick, wandert genügend darin enthaltener Heißhärter aus, um die Vernetzung des photopolymerisierten Epoxidharzes oder Phenol/Formaldehydharzes auszulösen. Zur gegenseitigen Verklebung der Schichten wird der Stapel erhitzt und verpreßt. Herkömmliche photopolymerisierbare Materialien bilden jedoch weder mit Kupfer noch mit harzimprägnierten Glasfaserfolien einen starken Verbund. Wird ein Stapel verklebt, während das Photopolymer noch das Kupfer überdeckt, so ist er deshalb an sich schwach und kann im Gebrauch auseinanderblättern. In der normalen Praxis entfernt man deshalb das restliche Photopolymer nach der Ätzstufe entweder mittels starker Lösungsmittel oder durch eine mechanische Methode, z. B. mit Bürsten. Ein solches Abstreifverfahren kann das Kupfer der gedruckten Schaltung oder die Oberfläche des Verbunds, auf dem die Schaltung liegt, beschädigen, und es besteht daher ein Bedarf für eine Methode, bei der es nicht mehr nötig wäre, das photopolymerisierte Material vor dem gegenseitigen Verkleben der Platten zu entfernen. Die Gegenwart verbleibender Vernetzungsgruppen in den erfindungsgemäßen Zusammensetzungen hat zur Folge, daß bei der Verklebung der Platten eine Vernetzung eintreten kann, was zu guter Haftung an Kupfer und am harzimprägnierten Glasfasersubstrat führt, so daß der eben erwähnte Schritt entfällt.

Eine weitere Anwendung der Heißhärtung nach der Photopolymerisation der erfindungsgemäßen Mischung betrifft das Filamentwickeln. Dabei wird ein endloses Kabel der faserförmigen Verstärkung mit einer einen latenten Heißhärter enthaltenden Mischung imprägniert und dann unter gleichzeitiger Belichtung der Wicklung mit aktinischer Strahlung um einen Dorn oder Spulkörper gewickelt. Derartige Filamentwicklungen besitzen noch einen gewissen Grad Biegsamkeit, was gestattet, den Dorn oder

Spulkörper leichter zu entfernen, als es bei einer in einem Schritt gebildeten starren Wicklung möglich wäre. Erforderlichenfalls kann man die Wicklung zur Vernetzung der Mischung erhitzen.

Bei einer weiteren solchen Anwendung wird eine Schicht der Mischung in flüssiger Form bis zur Verfestigung bestrahlt, wobei eine Klebfolie entsteht, die dann zwischen und in Berührung mit zwei zu verklebenden Oberflächen eingebracht wird, und der Aufbau wird erhitzt, um die Vernetzung der Mischung zu vervollständigen. Auf einer Seite kann die Folie mit einem abziehbaren Unterlegblatt, z. B. aus einem Polyolefin oder Polyester oder einem cellulosehaltigen Papier mit einer Silikonbeschichtung als Trennmittel, versehen sein. Häufig läßt sich der Aufbau leichter handhaben, wenn die Folie eine klebrige Oberfläche aufweist. Dies läßt sich dadurch erzielen, daß man die Folie mit einer Substanz beschichtet, die bei Raumtemperatur klebrig ist, aber unter den zur Vervollständigung der Vernetzung der Zusammensetzung angewandten Hitzebedingungen zu einem harten, unlöslichen, unschmelzbaren Harz vernetzt. Jedoch liegt ein ausreichender Klebrigkeitsgrad häufig ohne zusätzliche Behandlung vor, insbesondere wenn die Polymerisation der Mischung nicht zu weit fortgeschritten ist. Geeignete Klebsubstrate schließen Metalle wie Eisen, Zink, Cadmium, Kupfer, Nickel und Aluminium, Keramik, Glas und Kautschuktypen ein.

Die nachfolgenden Beispiele erläutern die Erfindung. Teile sind Gewichtsteile, falls nicht anders angegeben. Die Biegefestigkeiten stellen den Durchschnitt aus drei Ergebnissen dar und wurden nach British Standard Nr. 2782, Methode 304B, bestimmt.

Die in diesen Beispielen eingesetzten Carbamoylsulfoxoniumsalze wurden wie folgt hergestellt:

### Acetanilinodimethylsulfoxonium-hexafluorophosphat

10,5 Teile Dimethyl-N-phenylcarbamoyloxosulfonium-ylid, hergestellt wie von König und Metzger in Chem. Ber., 1965, 98, Seite 3740 beschrieben, werden in 110 Teilen einer 0,5 m Salzsäurelösung gelöst. Dazu gibt man unter Rühren eine Lösung von 9,5 Teilen Kaliumhexafluorophosphat in Wasser. Der weiße Niederschlag, der ausfällt, wird abfiltriert, mit Wasser gewaschen und in Ethanol umkristallisiert, wobei 8 Teile des gewünschten Produktes erhalten werden (Verbindung der Formel VI, Ar = $C_6H_5$, p = null, $R^6$ = H, $R^7$ = $R^8$ = $CH_3$, q = 1, t = 1, $Z^{t-}$ = $PF_6^-$) mit einem Schmelzpunkt von 141°–5°C; NMR (Aceton $-d_6$) 4.17 (s=6H), 5.41 (s=2H), 7.1 –7.6 (m=5H, 9.90 (s–1H); IR (KBr-Scheibe) 3310, 3030, 3015, 3000, 2960, 2920, 2880, 1665, 1600, 1560, 1490, 1440, 1340, 1240, 1030, 960, 840, 760 $cm^{-1}$; UV (Ethanol) $\lambda_{max}$ 269 nm.

### 3,4-Dichloracetanilinodimethylsulfoxonium-hexafluoroarsenat

Zu 56 Teilen Dimethyl-N-(3,4-dichlorphenyl)-carbamoyloxosulfonium-ylid, hergestellt nach der von König und Metzger beschriebenen Methode, werden 400 Teile einer 0,5 m Salzsäurelösung unter Rühren zugegeben und danach gibt man 46 Teile Kalium-hexafluoroarsenat, gelöst in 250 Teilen Wasser, unter Rühren zu. Nach 30 Minuten wird der Niederschlag abfiltriert, mit Wasser gewaschen und in Ethanol umkristallisiert. Dabei werden 27 Teile des gewünschten Produktes erhalten (Verbindung der Formel VI, Ar = 3,4-$Cl_2C_6H_3$, p = null, $R^6$ = H, $R^7$ = $R^8$ = $CH_3$, q = 1, t=1, $Z^{t-}$=$AsF_6^-$) mit einem Schmelzpunkt von 125°–9°C; NMR (Aceton $-d_6$) 4.22 (s–6H), 5.50 (s–2H), 7.50 (m–2H), 8.03 (m–1H), 10.50 (s–1H); IR (KBr-Scheibe) 3650, 3535, 3100, 3020, 2970, 2930, 2850, 1675, 1605, 1530, 1470, 1380, 1330, 1220, 1170, 1050, 710 $cm^{-1}$; UV (Ethanol) $\lambda_{max}$ 275 nm.

### p-Methylacetanilinodimethylsulfoxonium-hexafluorophosphat

22,5 Teile Dimethyl-N-(p-tolyl)-carbamoyloxosulfonium-ylid, hergestellt nach der Methode von König und Metzger, loc. cit., werden unter Rühren mit 200 Teilen 0,5 m Salzsäurelösung versehen. Danach gibt man unter Rühren eine wäßrige Lösung von 19 Teilen Kalium-hexafluorophosphat zu. Der dann ausfallende weiße Niederschlag wird abfiltriert, mit Wasser gewaschen und in Ethanol umkristallisiert. Man erhält 21 Teile der gewünschten Verbindung (der Formel VI, Ar = p-$CH_3C_6H_4$, p = null, $R^6$ = H, $R^7$ = $R^8$ = $CH_3$, q = 1, t=1, $Z^{t-}$=$PF_6^-$) mit einem Schmelzpunkt von 144–7°C; NMR (Aceton $-d_6$) 2.20 (s–3H), 4.13 (s–6H), 5.37 (s–2H), 7.35 (m–4H), 9,88 (s–1H); IR (KBr-Scheibe) 3380, 3020, 3000, 2940, 2920, 1675, 1600, 1540, 1510, 1400, 1320, 1240, 1040, 840 $cm^{-1}$; UV (Ethanol) $\lambda_{max}$ 269 nm.

### p-Methylacetanilinodimethylsulfoxoniumchlorid

Zu 22,5 Teilen Dimethyl-N-(p-tolyl)-carbamoyloxosulfonium-ylid, hergestellt nach der Methode von König und Metzger, loc. cit., werden unter Rühren 200 Teile 0,5 m Salzsäure zugegeben. Die Mischung wird filtriert und das Filtrat von Wasser befreit. Der Rückstand wird mit Toluol gewaschen und

getrocknet. Es werden 7 Teile des gewünschten Produktes (Verbindung der Formel VI, worin Ar = p-$CH_3C_6H_4$, p = null, $R^6$ = H, $R^7$ = $R^8$ = $CH_3$, q = 1, t=1, $Z^t$ =$Cl^-$) erhalten.

Benzoylcarbamoyldimethylsulfoxonium-hexafluorophosphat

4,8 Teile Dimethylsulfoxoniumbenzoylcarbamoylmethylid, hergestellt von Tsuge et al., in Tetrahedron, 1973, 29, 1983 beschrieben, werden unter Rühren mit 50 Teilen einer 0,5 m Salzsäurelösung versehen, und dann gibt man eine wäßrige Lösung von 3,7 Teilen Kaliumhexafluorophosphat hinzu. Der weiße Niederschlag wird abfiltriert, mit Wasser gewaschen und unter Vakuum getrocknet, wobei 7 Teile des gewünschten Produktes erhalten werden (Verbindung der Formel VI, Ar = $C_6H_5$, p = 1, $R^6$ = H, $R^7$ = $R^8$ = $CH_3$, q = 1, t = 1, $Z^{t-}$ = $PF_6^-$). NMR (Aceton $-d_6$) 4.19 (s–6H), 6.02 (s–2H), 7.5–8.2 (m–5H), 9.95 (s–1H); IR (KBr-Scheibe) 3320, 1710, 1680, 1460, 1360, 1320, 1240, 1170, 1040, 8.40, 7.10 $cm^{-1}$; UV (Ethanol) $\lambda_{max}$ 274 nm.

2,4-Bis-(dimethylsulfoxoniummethylcarbamoyl)-toluol-dihexafluorophosphat

3,6 Teile Bis-(dimethyloxosulphurylen-ylid), hergestellt durch Umsetzung von 1 Mol Toluol-2,4-diisocynat mit 2 Molen Dimethylsulfoxonium-methylid gemäß der genannten Methode von König und Metzger, werden in 40 Teilen einer 0,5 m Salzsäurelösung gerührt. 3,7 Teile Kalium-hexafluorophosphat, gelöst in Wasser, werden zugegeben, und die Mischung wird 15 Minuten gerührt. Der Niederschlag wird abfiltriert, mit Wasser gewaschen und unter Vakuum getrocknet. Es werden 5 Teile des gewünschten Produktes (Verbindung der Formel VI, worin Ar den Rest der Formel XXI bedeutet und

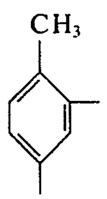

(XXI)

p = null, $R^6$ = H, $R^7$ = $R^8$ = $CH_3$, q = 2, t = 1, $Z^{t-}$ = $PF_6$ sind) erhalten.

p-Chloroacetanilinodimethylsulfoxonium-hexafluorophosphat

49 Teile Dimethyl-N-(p-chlorphenyl)-carbamoyloxosulfonium-ylid, hergestellt nach der bereits beschriebenen Methode von König und Metzger, werden in 400 Teilen 0,5 m Salzsäure gerührt und danach werden unter Rühren 37 Teile Kalium-hexafluorophosphat, gelöst in Wasser, zugegeben. Nach 30 Minuten wird der Niederschlag abfiltriert, mit Wasser gewaschen und getrocknet. Man erhält 60 Teile des gewünschten Produktes (Verbindung der Formel VI, Ar = p-$ClC_6H_4$, p = null, $R^6$ = H, $R^7$ = $R^8$ = $CH_3$, q = 1, t = 1, $Z^{t-}$ = $PF_6^-$), Fpt. 161–3°C; NMR (Aceton $-d_6$) 4.17 (s–6H), 5.43 (s–2H), 7.3–7,8 (m–4H), 10.05 (s–1H); IR (KBr-Scheibe) 3260, 3040, 2980, 2930, 1660, 1540, 1490, 1400, 1320, 1240, 1090, 1040, 840 $cm^{-1}$; UV (Ethanol) $\lambda_{max}$ 273 nm.

Tris-(acetanilinodimethylsulfoxonium)-orthophosphat

5 Teile Dimethyl-N-phenylcarbamoyloxosulfonium-ylid, hergestellt nach der bereits zitierten Methode von König und Metzger, werden zu 0,78 Teilen Orthophosphorsäure in 100 Teilen Wasser zugegeben. Dann wird die Lösung 2 Stunden lang gerührt und das Unlösliche durch Filtration abgetrennt. Das Filtrat wird unter vermindertem Druck zur Trockne eingeengt und das Produkt unter Vakuum getrocknet. Es werden 5,3 Teile des gewünschten Produktes (der Formel VI, Ar = $C_6H_5$, p = null, $R^6$ = H, $R^7$ = $R^8$ = $CH_3$, q = 1, t = 3, $Z^{t-}$ = $PO_4^{--}$$^-$) erhalten.

Acetanilinodimethylsulfoxonium-hexafluoroarsenat

6,3 Teile Dimethyl-N-phenylcarbamoyloxosulfonium-ylid werden in 30 Teilen 1 m Salzsäure gelöst. Unter Rühren werden 6,8 Teile Kaliumhexafluoroarsenat, gelöst in Wasser, zugegeben. Der weiße, ausfallende Niederschlag wird abfiltriert und mit Wasser gewaschen. Nach Umkristallisieren in Methanol erhält man 8 Teile des gewünschten Produktes (Verbindung der Formel VI, Ar = $C_6H_5$, p = null, $R^6$ = H, $R^7$ = $R^8$ = $CH_3$, q = 1, t = 1, $Z^{t-}$ = $AsF_6$) mit einem Schmelzpunkt von 146–7°C; NMR (Aceton $-d_6$) 4.17 (s–6H), 5.41 (s–2H), 7.1–7.6 (m–5H), 9.90 (s–1H), IR (KBr-Scheibe) 3310, 3030, 3015, 3000,

2960, 2920, 2880, 1665, 1600, 1560, 1490, 1440, 1340, 1240, 1030, 760, 705 $cm^{-1}$; UV (Ethanol) $\lambda_{max}$ 269 nm.

Beispiele 1—7

Mischungen aus je 98 Teilen Epoxidharz und 2 Teilen Carbamoylsulphoxoniumsalz werden hergestellt wie in der nachfolgenden Tabelle angeführt und als 10 µm dicke Filme auf Weißblech aufgezogen und dann im Abstand von 8 cm der Strahlung einer Mitteldruckquecksilberbogenlampe (8 W pro cm) in der angegebenen Zeit ausgesetzt. In jedem Fall wird eine klebfreie Beschichtung erhalten.

| Beispiel Nr. | Epoxid-Harz | Carbamoylsulphoxoniumsalz | Bestrahlungsdauer (Sek.) |
|---|---|---|---|
| 1 | 2,2-Bis-(p-glycidyl-oxyphenyl)-propane | Acetanilinodimethylsulphoxonium-hexafluorophosphat | 30 |
| 2 | 2,2-Bis-(p-glycidyl-oxyphenyl)-propane | Acetanilinodimethylsulphoxonium-hexafluoroarsenat | 30 |
| 3 | 2,2-Bis-(p-glycidyl-oxyphenyl)-propane | 3,4-Dichloracetanilinodimethylsulph-oxonium-hexafluoroarsenat | 20 |
| 4 | 2,2-Bis-(p-glycidyl-oxyphenyl)-propane | p-Methylacetanilinodimethylsulph-oxonium-hexafluorophosphat | 15 |
| 5 | 2,2-Bis-(p-glycidyl-oxyphenyl)-propane | Benzoylcarbamoyldimethylsulph-oxonium-hexafluorophosphat | 30 |
| 6 | 2,2-Bis-(p-glycidyl-oxyphenyl)-propane | 2,4-Bis-(dimethylsulphoxoniummethyl-carbamyl)-toluol-dihexafluorophosphat | 60 |
| 7 | 3,4-Epoxycyclohexylmethyl-3,4-epoxycyclohexan-carboxylat | 3,4-Dichloracetanilinodimethylsulph-oxonium-hexafluoroarsenat | 10 |

Beispiel 8

Unter den in den Beispielen 1 bis 7 angewendeten Bedingungen wird eine Mischung aus 4 Teilen p-Chloracetanilinodimethylsulphoxonium-hexafluorophosphat und 96 Teilen 2,2-Bis-(p-glycidyloxyphenyl)-propane bestrahlt. Nach 10 Sekunden wird eine klebfreie Beschichtung erhalten.

Beispiel 9

Eine Mischung aus 2 Teilen 3,4-Dichloracetanilinodimethylsulphoxonium-hexafluoroarsenat und 98 Teilen 3,4-Dihydro-2H-pyran-2-methyl-3,4-dihydro-2H-pyran-2-carboxylat wird als 10 µm dicker Film auf Weißblech während 20 Sekunden wie in Beispielen 1 bis 7 bestrahlt. Dabei wird eine klebfreie Beschichtung erhalten.

Beispiel 10

Man verfährt wie in Beispiel 9, verwendet jedoch anstelle des Vinyläthers ein handelsübliches Phenol-Formaldehydharz mit einem molaren Verhältnis von Phenol zu Formaldehyd von 1 : 1,6 und als Katalysator p-Methylacetanilinodimethylsulphoxoniumchlorid. Nach 5 Sekunden Bestrahlungsdauer wird ein fester, klebfreier, lösungsmittelbeständiger Überzug erhalten.

## Beispiel 11

Man verfährt wie in Beispiel 9, verwendet jedoch anstelle des Vinyläthers ein handelsübliches Harnstoff-Formaldehydharz (Gehalt an harzbildenden Feststoffen 70%, H: F-Molverhältnis 1 : 1,8). Nach 5 Sekunden Bestrahlungsdauer wird ein klebfreier, lösungsmittelbeständiger Überzug erhalten.

## Beispiel 12

Eine Mischung aus 100 Teilen des in Beispiel 9 verwendeten Harnstoff-Formaldehydharzes und 2 Teilen Tris-(acetanilinodimethylsulphoxonium)-orthophosphat wird in Form von 10 μm dicken Filmen, die unter den in Beispielen 1 bis 7 angewendeten Bedingungen hergestellt werden, bestrahlt. Nach 5 Sekunden Bestrahlung wird ein klebfreier Überzug erhalten.

## Beispiel 13

Dieses Beispiel erläutert die Verwendung eines Sensibilisators. Man bringt einen Anteil der in Beispiel 4 beschriebenen Mischung als 10 μm dicken Film auf Weißblech auf und bestrahlt die Beschichtung aus einer Entfernung von 22 cm mit einer 400 W Hochdruckmetallhalogenidquarzlampe. Diese Lampe mit einer Strahlung vorwiegend im 360 mm Band wird absichtlich als eine unwirksame Polymerisationsenergiequelle gewählt. Nach 15 Minuten Bestrahlung war die Schicht noch nicht vollständig klebfrei. Danach wurde zu einem anderen Anteil der Mischung 5 Gewichts-%Pyren zugegeben und der Film dieser Mischung wurde in der gleichen Weise wie oben bestrahlt. Nach 8 Minuten war der Film klebfrei.

## Beispiel 14

Dieses Beispiel erläutert ein zweistufiges Härtungsverfahren, bei dem zuerst eine Epoxidharzmischung photopolymerisiert wird und danach durch den ebenfalls in der Mischung enthaltenen latenten Heißhärtungskatalysator bei Erhitzen vernetzt wird.

Ein Glastuch wird mit einer flüssigen Mischung, enthaltend 75 Teile 2,2-Bis-(p-glycidyloxyphenyl)-propan (Epoxidgehalt: 5,2 Äquivalente/kg), 25 Teile eines Polyglycidyläthers eines Phenol-Formaldehyd-Novolaks (Epoxidgehalt von 5,6 Äquivalente/kg), 4 Teile eines Bortrichlorid/Triäthylaminkomplexes und 2 Teile 3,4-Dichloracetanilinodimethylsulphoxonium-hexafluoroarsenat imprägniert. Beide Seiten des imprägnierten Glastuches werden im Abstand von 8 cm mit einer Mitteldruckbogenlampe (80 W pro cm) während 60 Sekunden bestrahlt, wobei die Mischung fest wird. Ein Laminat aus sechs Lagen wird erhalten durch Verpressen von 10 $cm^2$ großen Stücken bei 200°C während 1 Stunde unter einem Druck von 1,05 $MN/m^2$. Das Laminat, welches aus 64% Glas besteht, weist eine Biegfestigkeit von 380 $MN/m^2$ auf.

## Beispiel 15

Dieses Beispiel erläutert die Kombinationshärtung eines Epoxidharzes mit einem mehrwertigen Alkohol. Man bringt eine Mischung aus 20 Teilen 3,4-Epoxycyclohexylmethyl-3,4-epoxycyclohexancarboxylat, 10 Teilen eines handelsüblichen Styrol/Allylalkohol-Copolymeren (Hydroxylgehalt: 3,56 Äquivalente/kg) und 1,2 Teilen p-Chloracetanilinodimethylsulphoxonium-hexafluorophosphat als 10 μm dicke Beschichtung auf Weißblech auf und bestrahlt diese mit einer Mitteldruckquecksilberbogenlampe. Nach 30 Sekunden Bestrahlung wird ein klebfreier Film erhalten.

## Beispiel 16

Dieses Beispiel erläutert die Herstellung eines Fotoresists.

Man bereitet eine Lösung von 1 g Diglycidyläther des 2,2-Bis-(4-hydroxyphenyl)-propans, 4 g Tetraglycidyläther des 1,1,2,2-Tetra-(4-hydroxyphenyl)-äthans, 5 g Diglycidyläther des 2,2-Bis-(4-hydroxyphenyl)-propans, der mit einem bromhaltigen Phenol auf einen Erweichungspunkt von 50°C vorverlängert ist und einen Epoxidgehalt von 2 val/kg aufweist und 0,4 g p-Chloracetanilinodimethylsulphoxonium-hexafluorophosphat in 10 g Cyclohexanon. Man beschichtet kupferkaschiertes Plattenmaterial und läßt das Lösungsmittel verdunsten, wobei ein etwa 10 μm dicker Film verbleibt. Dieser wird unter Verwendung einer 500 W Mitteldruckquecksilberlampe im Abstand von 22 cm durch ein Negativ hindurch 60 Minuten lang bestrahlt. Nach der Bestrahlung wird das Bild in Toluol entwickelt, wobei die unbelichteten Stellen ausgewaschen werden und ein gutes Reliefbild auf dem Kupfer verbleibt.

**Patentansprüche**

1. Mischungen, enthaltend

(a) eine Verbindung bzw. ein Gemisch von Verbindungen, die unter dem Einfluß eines kationischen Katalysators in höhermolekulares Material überführbar sind, und
(b) als Katalysator eine wirksame Menge eines Carbamoylsulfoxoniumsalzes der Formel VI

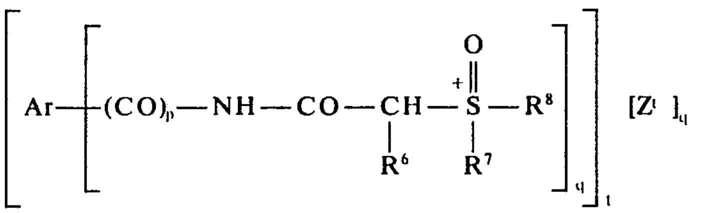

(VI)

worin

p Null oder 1 bedeutet,
q für eine ganze Zahl von 1 bis 4 steht,
Ar einen q-valenten aromatischen Rest darstellt, der 4 bis 25 C-Atome enthält und über eines seiner Kohlenstoffatome direkt an das angegebene Carbonylkohlenstoffatom gebunden ist, wenn p = 1 ist, oder wenn p = null ist an das angegebene Stickstoffatom,
$R^6$ ein Wasserstoffatom oder eine Gruppe der Formel VII oder VIII

$COR^9$ (VII)

oder

$-CONH(CO)_r-R^{10}$ (VIII)

bedeutet,
$R^7$ ein Alkyl mit 1 bis 18 C-Atomen, ein Alkenyl mit 2 bis 6 C-Atomen, ein Cycloalkyl mit 3 bis 8 C-Atomen, ein Cycloalkylalkyl mit 4 bis 10 C-Atomen, ein Aryl mit 4 bis 24 C-Atomen oder ein Aralkyl mit 5 bis 16 C-Atomen bedeutet,
$R^8$ dieselbe Bedeutung wie $R^7$ hat, aber auch für eine Dialkylaminogruppe mit 2 bis 6 C-Atomen oder, falls $R^7$ ein besagtes Alkyl darstellt, auch für eine Arylaminogruppe mit 4 bis 8 C-Atomen stehen kann,
$R^9$ eine monovalente gesättigte oder ethylenisch ungesättigte Gruppe mit 1 bis 12 C-Atomen, die direkt durch ein C-Atom an die Carbonylgruppe der Formel VII gebunden ist, bedeutet,
r gleich null oder 1 ist,
$R^{10}$ eine monovalente gesättigte oder ethylenisch ungesättigte Gruppe mit 1 bis 12 C-Atomen bedeutet, die, wenn r = null ist, direkt über eines ihrer C-Atome an das Stickstoffatom gebunden ist, oder, wenn r für 1 steht, an das Carbonylkohlenstoffatom gebunden ist,
t 1, 2 oder 3 darstellt, und
$Z^{t-}$ ein t-valentes Anion einer Protonensäure bedeutet, wobei, falls (a) ein 1,2-Epoxid ist, $Z^{t-}$ ein Anion der Formel XI

$MX_n^-$ (XI)

worin M für ein Metall oder Metalloidatom und X für ein Halogenatom, stehen und n 4, 5 oder 6 und um eins höher als die Wertigkeit von M ist, oder der Formel XII

$SbF_5(OH)^-$ (XII)

bedeutet.

2. Mischung gemäß Anspruch 1, dadurch gekennzeichnet, daß Ar in Formel VI ein mono- oder dicyclisches Aryl oder Aralkyl mit 6 bis 16 C-Atomen bedeutet.

3. Mischung gemäß Anspruch 1, dadurch gekennzeichnet, daß Ar in Formel VI ein mono- oder dicyclisches Arylen oder Aralkylen mit 6 bis 16 C-Atomen bedeutet.

4. Mischung gemäß Anspruch 1, dadurch gekennzeichnet, daß in Formel VI $R^7$ und $R^8$ je ein Alkyl mit 1 bis 4 C-Atomen, ein Phenyl oder Naphthyl, die am aromatischen Ring durch 1 oder 2 Alkyle mit je 1 bis 4 C-Atomen, 1 oder 2 Alkoxyle mit je 1 bis 4 C-Atomen oder durch 1 oder 2 Fluor-, Chlor- oder Bromatome substituiert sein können, und $R^9$ und $R^{10}$ je eine aliphatische Gruppe mit 1 bis 8 C-Atomen bedeuten.

5. Mischung gemäß Anspruch 1, worin in Formel VI $Z^{t-}$ für eines der Anionen $Cl^-$, $Br^-$, $NO_3^-$, $HSO_4^-$, $HSO_3^-$, $ClO_4^-$, $CF_3SO_3^-$, $CF_3COO^-$, $C_6H_5SO_3^-$, $CH_3C_6H_4SO_3^-$, $H_2PO_4^-$, $SO_4^{--}$, $PO_4^{---}$, $SbF_5(OH)^-$, oder für ein Anion der Formel XI

$$MX_n^- \qquad (XI)$$

steht, worin

M ein Antimon-, Wismut-, Bor-, Arsen- oder Phosphoratom darstellt,
X ein Fluor- oder Chloratom bedeutet und n für 4, 5 oder 6 steht und um eins höher als die Wertigkeit von M ist.

6. Mischung gemäß Anspruch 1, dadurch gekennzeichnet, daß sie als Komponente (b) ein Acetanilinodimethylsulfoxonium-hexafluorophosphat, Acetanilinodimethylsulfoxonium-hexafluoroarsenat, 3,4-Dichloracetanilinodimethylsulfoxonium-hexafluoroarsenat, p-Methylacetanilinodimethylsulfoxonium-hexafluorophosphat, Benzoylcarbamoyldimethylsulfoxonium-hexafluorophosphat, 2,4-Bis-(dimethylsulfoxonium-methylcarbamoyl)-toluol-dihexafluorophosphat, p-Chloracetanilinodimethylsulfoxonium-hexafluorophosphat, p-Methylacetanilinodimethylsulfoxonium-chlorid, oder Tris-(acetanilinodimethylsulfoxonium)-orthophosphat enthält.

7. Mischung gemäß Anspruch 1, dadurch gekennzeichnet, daß die Komponente (a) ein 1,2-Epoxid, ein Vinylmonomer oder -präpolymer, ein Amino- oder Phenoplast ist.

8. Mischung gemäß Anspruch 7, dadurch gekennzeichnet, daß die Komponente (a) ein Epoxidharz oder ein aus einem Phenol und einem Aldehyd hergestelltes Resolharz ist.

9. Mischung gemäß Anspruch 1, dadurch gekennzeichnet, daß sie 0,1 bis 7,5 Gewichtsteile (b) auf 100 Gewichtsteile (a) enthält.

10. Mischung gemäß Anspruch 9, dadurch gekennzeichnet, daß sie ferner eine ausreichende Menge eines latenten Heißhärters für das Epoxidharz bzw. Resolharz enthält.

**Claims**

1. A composition comprising

a) a compound, or mixture of compounds, capable of being transformed into a higher-molecular weight material under the influence of a cationic catalyst,
b) as catalyst, an effective amount of a carbamoylsulphoxonium salt of the formula

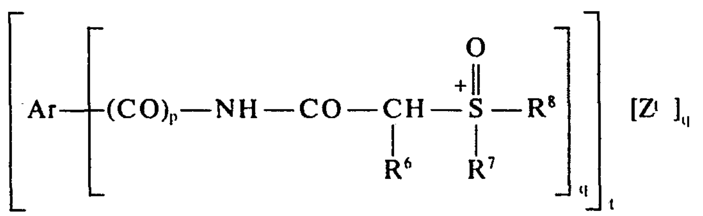

(VI)

where

p is zero or 1,
q is an integer of from 1 to 4,
Ar denotes an aromatic group of valency q, having from 6 to 25 carbon atoms and being directly linked through a carbon atom thereof to the carbon atom of the indicated adjacent carbonyl group if p is 1 or to the indicated nitrogen atom if p is zero,
$R^6$ denotes a hydrogen atom, or a group of formula

$$-COR^9 \qquad (VII)$$

or

$$-CONH(CO)_r-R^{10} \qquad (VIII)$$

$R^7$ denotes an alkyl group of 1 to 18 carbon atoms, an alkenyl group of 2 to 6 carbon atoms, a cycloalkyl group of 3 to 8 carbon atoms, a cycloalkylalkyl group of 4 to 10 carbon atoms, an aryl group of 6 to 24 carbon atoms, or an aralkyl group of 5 to 16 carbon atoms,
$R^8$ has the same meaning as $R^7$ but may alternatively represent a dialkylamino group of 2 to 6 carbon atoms or, if $R^7$ denotes a said alkyl group, it may alternatively represent an arylamino group of 4 to 8 carbon atoms,

$R^9$ denotes a monovalent saturated or ethylenically unsaturated group of 1 to 12 carbon atoms, directly linked through a carbon atom thereof to the —CO— group shown in formula VII,

r is zero or 1,

$R^{10}$ denotes a monovalent saturated or ethylenically unsaturated group of 1 to 12 carbon atoms, directly linked through a carbon atom thereof to, if r denotes zero, the indicated nitrogen atom, or, if r denotes 1, the carbon atom of the indicated carbonyl group,

t is 1, 2 or 3, and

$Z^t$ is an anion of a protic acid of valency t, with the proviso that, if (a) is a 1,2-epoxide, $Z^{t-}$ is an anion of formula XI

$$MX_n^- \quad (XI)$$

wherein M is a metal or metalloid atom and X is a halogen atom and n is 4, 5 or 6 and is one more than the valency of M, or is an anion of formula (XII)

$$SbF_5(OH)^- \quad (XII)$$

2. A composition according to claim 1, in which Ar represents a monocyclic or dicylic aryl or aralkyl group of 6 to 16 carbon atoms.

3. A composition according to claim 1, in which Ar represents a monocyclic or dicyclic arylene or aralkylene group of 6 to 16 carbon atoms.

4. A composition according to claim 1, in which $R^7$ and $R^8$ are each an alkyl group of 1 to 4 carbon atoms, or a phenyl or a naphthyl group which may be substituted in the aromatic ring or rings by one or two alkyl groups, each of 1 to 4 carbon atoms, or by one or two alkoxy groups, each of 1 to 4 carbon atoms, or by one or two fluorine, chlorine, or bromine atoms, and $R^9$ and $R^{10}$ are each an aliphatic group of 1 to 8 carbon atoms.

5. A composition according to claim 1, wherein $Z^-$ is an anion selected from $Cl^-$, $Br^-$, $NO_3^-$, $HSO_4^-$, $HSO_3^-$, $ClO_4^-$, $CF_3SO_3^-$, $CF_3COO^-$, $C_6H_5SO_3^-$, $CH_3C_6H_4SO_3^-$, $H_2PO_4^-$, $SO_4^{--}$, $PO_4^{---}$, $SbF_5(OH)^-$, or is an anion of formula

$$MX_n^- \quad (XI)$$

wherein

M denotes an antimony, bismuth, boron, arsenic or phosphorus atom,

X denotes a fluorine or chlorine atom, and

n is 4, 5, or 6 and is one more than the valency of M.

6. A composition according to claim 1, in which b) is acetanilinodimethylsulphoxonium hexafluorophosphate, acetanilinodimethylsulphoxonium hexafluoroarsenate, 3,4-dichloroacetanilinodimethylsulphoxonium hexafluoroarsenate, p-methylacetanilinodimethylsulphoxonium hexafluorophosphate, benzoylcarbamoyldimethylsulphoxonium hexafluorophosphate, 2,4-bis(dimethylsulphoxoniummethylcarbamoyl)toluene dihexafluorophosphate, p-chloroacetanilinodimethylsulphoxonium hexafluorophosphate, p-methylacetanilinodimethylsulphoxonium chloride or tris(acetoanilinodimethylsulphoxonium orthophosphate.

7. A composition according to claim 1, wherein component a) is a 1,2-epoxide, a vinyl monomer or vinyl prepolymer, an aminoplast or a phenoplast.

8. A composition according to claim 7, wherein component a) is an epoxy resin or a resol made from a phenol and an aldehyde.

9. A composition according to claim 1, containing 0.1 to 7.5 parts by weight of b) per 100 parts by weight of a).

10. A composition according to claim 9, which also contains a curing amount of a latent heat-curing agent for the epoxide resin or resol resin.

**Revendications**

1. Mélanges contenant:

(a) un composé, ou un mélange de composés, que l'on peut transformer sous l'influence d'un catalyseur cationique en une matière à poids moléculaire élevé, et

(b) à titre de catalyseur, une quantité efficace d'un sel de carbamoylsulfoxonium de formule VI:

$$\left[ Ar - \left[ (CO)_p - NH - CO - \underset{R^6}{\underset{|}{CH}} - \underset{R^7}{\underset{|}{\overset{O}{\overset{+\|}{S}}}} - R^8 \right]_q \right]_t [Z^{t-}]_q \qquad (VI)$$

dans laquelle:

p est nul ou vaut 1,

q est un nombre entier valant 1 à 4,

Ar représente un reste aromatique de valence q, qui contient 4 à 25 atomes de carbone et est relié par ses atomes de carbone directement à l'atome de carbone du groupe carbonyle indiqué, quand p vaut 1, ou bien, quand p est nul, à l'atome d'azote indiqué,

$R^6$ est un atome d'hydrogène ou un groupe de formule VII ou VIII:

$$COR^9 \qquad (VII)$$

ou

$$-CONH(CO)_r-R^{10} \qquad (VIII)$$

$R^7$ représente un groupe alkyle ayant 1 à 18 atomes de carbone, un groupe alcényle ayant 2 à 6 atomes de carbone, un groupe cycloalkyle ayant 3 à 8 atomes de carbone, un groupe cycloalkylalkyle ayant 4 à 10 atomes de carbone, un groupe aryle ayant 4 à 24 atomes de carbone ou aralkyle ayant 5 à 16 atomes de carbone,

$R^8$ a le même sens que $R^7$, mais il peut aussi représenter un groupe dialkylamino ayant 2 à 6 atomes de carbone ou bien, si $R^7$ représente un groupe alkyle comme indiqué ci-dessus, $R^8$ peut aussi représenter un groupe arylamino ayant 4 à 8 atomes de carbone,

$R^9$ représente un groupe monovalent, saturé ou à insaturation éthylénique, comportant 1 à 12 atomes de carbone, qui est relié directement par un atome de carbone au groupe carbonyle de formule VII,

r est nul ou vaut 1,

$R^{10}$ représente un groupe monovalent, saturé ou à insaturation éthylénique, comportant 1 à 12 atomes de carbone et qui, quand r est nul, est relié directement par un de ses atomes de carbone à l'atome d'azote ou bien, quand r vaut 1, à l'atome de carbone de groupe carbonyle,

t vaut 1, 2 ou 3, et

$Z^{t-}$ représente un anion de valence t d'un acide protonique et, si (a) est un époxyde-1,2, $Z^{t-}$ représente un anion de formule XI:

$$MX_n^- \qquad (XI)$$

(dans laquelle M représente un atome de métal ou de métalloïde, X représente un atome d'halogène et n vaut 4, 5 ou 6 et a une valeur supérieure de 1 à la valence de M), ou de formule XII:

$$SbF_5(OH)^- \qquad (XII)$$

2. Mélange selon la revendication 1, caractérisé en ce que, dans la formule VI, Ar représente un groupe aryle ou aralkyle monocyclique ou dicyclique ayant 6 à 16 atomes de carbone.

3. Mélange selon la revendication 1, caractérisé en ce que, dans la formule VI, Ar représente un groupe arylène ou aralkylène monocyclique ou dicyclique ayant 6 à 16 atomes de carbone.

4. Mélange selon la revendication 1, caractérisé en ce que, dans la formule VI, $R^7$ et $R^8$ représentent chacun un groupe alkyle ayant 1 à 4 atomes de carbone, un groupe phényle ou naphtyle pouvant porter comme substituant sur le noyau aromatique un ou deux groupes alkyles ayant chacun 1 à 4 atomes de carbone, un ou deux alcoxyles ayant chacun 1 à 4 atomes de carbone ou 1 ou 2 atomes de fluor, de chlore ou de brome, et $R^9$ et $R^{10}$ représentent chacun un groupe aliphatique ayant 1 à 8 atomes de carbone.

5. Mélange selon la revendication 1, dans lequel, dans la formule VI, $Z^{t-}$ représente l'un des anions $Cl^-$, $Br^-$, $NO_3^-$, $HSO_4^-$, $HSO_3^-$, $ClO_4^-$, $CF_3SO_3^-$, $CF_3COO^-$, $C_6H_5SO_3^-$, $CH_3C_6H_4SO_3^-$, $H_2PO_4^-$, $SO_4^{--}$, $PO_4^{---}$, $SbF_5(OH)^-$, ou un anion de formule XI:

$$MX_n^- \qquad (XI)$$

dans laquelle:

M représente un atome d'antimoine, de bismuth, de bore, d'arsenic ou de phosphore,
X représente un atome de fluor ou de chlore et n vaut 4, 5 ou 6 et est supérieur de un à la valence de M.

6. Mélange selon la revendication 1, caractérisé en ce qu'il contient comme composant (b) un hexafluorophosphate d'acétanilinodiméthylsulfoxonium, un hexafluoroarséniate d'acétanilinodiméthylsulfoxonium, un hexafluoroarséniate de dichloro-3,4 acétanilinodiméthylsulfoxonium, un hexafluorophosphate de p-méthyl-acétanilinodiméthylsulfoxonium, un hexafluorophosphate de benzoylcarbamoyldiméthylsulfoxonium, le dihexafluorophosphate de bis-(diméthylsulfoxonium-méthylcarbamoyl)-2,4 toluène, l'hexafluorophosphate de p-chloroacétanilinodiméthylsulfoxonium, le chlorure de p-méthylacétanilinodiméthylsulfoxonium ou l'orthophosphate de tris-(acétanilinodiméthylsulfoxonium).

7. Mélange selon la revendication 1, caractérisé en ce que le composant (a) est un époxyde-1,2, un monomère ou prépolymère vinylique, un aminoplaste ou un phénoplaste.

8. Mélange selon la revendication 7, caractérisé en ce que le composant (a) est une résine époxyde ou une résine de type résol préparée à partir d'un phénol et d'un aldéhyde.

9. Mélange selon la revendication 1, caractérisé en ce qu'il contient 0,1 à 7,5 parties en poids de (b) pour 100 parties en poids de (a).

10. Mélange selon la revendication 9, caractérisé en ce qu'il contient en outre une quantité suffisante d'un durcisseur latent, agissant à chaud, de la résine époxyde ou de la résine de type résol.